# EUROPÄISCHE PATENTSCHRIFT

(11) **EP 1 417 042 B1**
(45) Veröffentlichungstag und Bekanntmachung des Hinweises auf die Patenterteilung: **23.01.2013**
(21) Anmeldenummer: 02748647.1
(22) Anmeldetag: 28.03.2002
(51) Int. Cl.: B05D 7/24

(54) **VERFAHREN ZUR HERSTELLUNG EINES BESCHICHTETEN KUNSTSTOFFKÖRPERS**
METHOD FOR PRODUCING A COATED SYNTHETIC BODY
PROCEDE DE PRODUCTION D'UN CORPS SYNTHETIQUE REVETU

(30) Priorität: 29.03.2001 EP 01107967; 29.03.2001 EP 01107966; 21.12.2001 DE 10163625
(43) Veröffentlichungstag der Anmeldung: 12.05.2004
(73) Patentinhaber: Schott AG, 55122 Mainz (DE)
(72) Erfinder: KUHR, Markus, 55579 Wöllstein (DE); WOLFF, Detlef, 55129 Mainz (DE); WALTHER, Marten, 55270 Engelstadt (DE); BEHLE, Stephan, 55278 Hahnheim (DE); BAUER, Stefan, 55232 Alzey (DE); KLIPPE, Lutz, 65187 Wiesbaden (DE); MOELLE, Christoph, 37581 Bad Gandersheim (DE); BEWIG, Lars, 37581 Bad Gandersheim (DE); KOPPE, Frank, 37581 Bad Gandersheim (DE); KÜPPER, Thomas, 37581 Bad Gandersheim (DE); MARING, Wolfram, 22337 Hamburg (DE); HEINZ, Jochen;, 24149 Kiel (DE)
(74) Vertreter: Blumbach Zinngrebe
(86) Internationale Anmeldenummer: PCT/EP2002/003528
(87) Internationale Veröffentlichungsnummer: WO 2002/094458

(56) Entgegenhaltungen:
- EP-A- 0 801 146
- DE-A- 19 740 806
- US-A- 5 051 308
- US-A- 5 643 638
- US-A- 5 900 285

## Beschreibung

Die Erfindung betrifft das Beschichten eines Kunststoffsubstrates zum Erzeugen eines beschichteten Körpers, eine Vorrichtung zur Durchführung eines solchen Verfahrens, sowie dessen Verwendung.

Dabei handelt es sich um Körper jeglicher Art und Gestalt. In Betracht kommen insbesondere gekrümmte Körper oder leicht gekrümmte Körper, beispielsweise Brillengläser. Ferner kommen flache oder annähernd flache Körper wie Display-Abdeckscheiben in Betracht, z. B. bei Mobilfunkgeräten, Telefon-Feststationen, usw.. Bei dem genannten Kunststoff handelt es sich z. B. um Polymethylmethacrylat (PMMA) sowie dessen Derivate oder mit diesem wesensgleiche Kunststoffe. PMMA hat sich bei den verschiedenen Anwendungsgebieten sehr bewährt und ist kostengünstig.

Die Beschichtung ist eine Mehrfachbeschichtung. Die einzelnen Schichten sind optische Funktionsschichten wie zum Beispiel eine Anti-Reflex-Schicht bzw. ein aus mehreren Einzelschichten bestehendes Anti-Reflex-Schicht-System, aber auch Schichten mit besonderen mechanischen Eigenschaften wie beispielsweise eine hydrophobe Deckschicht, die sogenannte Reinigungsschicht, die sich mechanisch leicht reinigen lässt, oder eine Antikratzschicht. Zwischen den Funktionsschichten und dem Substrat wird im allgemeinen eine sogenannten Haftvermittler-Schicht aufgebracht, hier ganz allgemein "Zwischenschicht" genannt. Dieser kommt entscheidende Bedeutung für die Brauchbarkeit des ganzen Produktes zu. Sie ist nämlich für die Haftung des gesamten Schichtpaketes am Substrat verantwortlich. Die Zwischenschicht kann eine einzige homogene Schicht sein. Sie kann auch eine Mehrlagenschicht sein. Dabei bilden die einzelnen Schichten einen Gradienten, ausgehend von einer Schicht, die unmittelbar auf das Substrat folgt und diesem als Organikum wesensgleich oder ähnlich ist, bis zu einer Schicht, die der nächstfolgenden Funktionsschicht nahe ist und die dieser als Anorganikum wesensgleich oder ähnlich ist.

Beschichtete optische Komponenten aus organischen Polymeren ersetzen für verschiedene Anwendungen in zunehmendem Maße Komponenten aus Glas, da sie eine Reihe von Vorteilen bieten. Polymere können in einem Arbeitsgang, daher ohne aufwendige Nachbearbeitung, mit hoher Oberflächenqualität gefertigt werden. Die Massenherstellung ist daher vergleichsweise kostengünstig. Zudem bieten Polymere bessere Möglichkeiten der Formgebung, der Miniaturisierung und auch der Mikrostrukturierung von Oberflächen. Für bestimmte Anwendungsfälle ist das geringere Gewicht von Polymeren vorteilhaft.

Polymere Bauteile mit Interferenzbeschichtung für optische Anwendungen werden gegenwärtig durch ionengestütztes Bedampfen beschichtet. Dabei können die Polymere beispielsweise mit einem Anti-Reflex-Schichtsystem beschichtet werden. Bei der Beschichtung von Polymeren sind einige Besonderheiten im Vergleich zu den etablierten Beschichtungsprozessen für Glassubstrate zu beachten. Da sich thermische und mechanische Eigenschaften der Polymere erheblich von den Eigenschaften sowohl von Glas als Substratmaterial als auch der gängigen dielektrischen Schichtmaterialien, wie TiO₂ und SiO₂ unterscheiden, werden hohe änwendungsspezifische Anforderungen an die Substrat-Schicht-Haftung und die Langzeitstabilität des Schichtsystems gestellt. Der gesamte Prozess von der Materialauswahl über die Herstellung der Substrate bis zum eigentlichen Beschichtungsverfahren muss im Hinblick auf diese Anforderungen ausgelegt werden. Hohe thermische Wechselbelastungen, wie sie zum Beispiel in optischen Systemen mit sehr hoher Lichtleistung oder Energiedichte auftreten, überschreiten häufig noch die Belastungsgrenzen für die Schichthaftung und die Lebensdauer der beschichteten optischen Polymere. Zudem sind Polymere temperaturempfindlich und können daher bei der Beschichtung nur einer geringen Wärmebelastung ausgesetzt werden.

Es sind zahlreiche Verfahren zum Herstellen von Gegenständen der genannten Art bekannt, das heißt von Kunststoffsubstraten mit hierauf befindlichen Schichten.

WO 01/07678 A1 betrifft die Abscheidung rein anorganischer Schichten, insbesondere auf anorganischen Substraten. Auf das Problem der Haftung von anorganischen Schichten auf Kunststoff, d.h. organischen Substraten wird in dieser Schrift weder eingegangen noch wird eine Lösung hierfür offenbart.

DE 197 40 806 A1 beschreibt Mikrotiterplatten aus Kunststoff, welche zur Erhöhung der chemischen Resistenz der Mikrotiterplatte gegen organische Lösungsmittel mit einer Schicht aus SiOₓC_{y}H_{z} und/oder TiOₓC_{y}H_{z} versehen sind. Diese Schrift betrifft jedoch weder optische Schichten noch Antikratzschichten auf Kunststoffsubstraten.

US 5,900,285 betrifft Barrierebeschichtungen auf insbesondere Polycarbonat. Es werden jedoch keine optischen Beschichtungen, insbesondere nicht solche auf PMMA beschrieben.

EP 0 752 483 A1 und DE 195 23 444 A1 betreffen die Beschichtung von Metall- und Kunststoffoberflächen mittels eines PACVD-Verfahrens (PACVD Plasmaunterstütztes CVD-Verfahren). Die angewandten Beschichtungsbedingungen sind jedoch relativ drastisch, so dass insbesondere bei den benötigten Beschichtungszeiten von einer Stunde und insbesondere auf PMMA Schädigungen des Substrats auftreten.

Gemäß EP 0 285 870 wird das Substrat für eine bessere Beschichtung auf 100°C oder mehr aufgeheizt. Eine solche Temperaturbelastung des Substrats ist insbesondere im Fall von PMMA nicht wünschenswert und führt zu einer beschädigten Substratoberfläche. Ferner wird die Haftschicht gemäß dieser Schrift nicht durch ein CVD-Verfahren aufgetragen.

DE 197 03 538 A1 beschreibt ein Verfahren zum Modifizieren von Oberflächen von PMMA-Substraten. Hierbei wird die Substrat-Oberfläche mit einer schützenden Schicht versehen. Damit soll sich eine verbesserte Haftung für nachfolgend aufzubringende Funktionsschichten erreichen lassen. Das Aufbringen der genannten Schutzschicht stellt einen zusätzlichen Verfahrensschritt dar und bedeutet somit zusätzlichen Aufwand und Kosten.

Weitere Verfahren zum Aufbringen dünner Schichten auf Kunststoff-Substraten sind in DE 34 13 019 A1, EP 0 422 323 A1, DE 40 04 116 A1 und anderen beschrieben. Dabei geht es unter anderem auch um die Haftung der Schicht, die auf das Substrat aufgebracht wird, und zwar mittels des GVD- oder PECVD-Verfahrens. DE 100 10 766 zeigt und beschreibt ein Verfahren und eine Vorrichtung zur Beschichtung von insbesondere gekrümmten Substraten, beispielsweise von Brillengläsern.

Das Dokument EP 801 146 A1 zeigt ein PECVD-Verfahren, bei welchem Kunststoffsubstrate mit einem Mehrschichtsystem beschichtet werden. Das Dokument liefert keine Hinweise darauf, die Energiebelastung des Substrats durch Einstellen von Pulsdauer und Pulspause bei Durchführung des Verfahrens niedrig zu halten, insbesondere bei einer Temperatur von unter 40° Celsius.

Die bisher angewandten Verfahren haben nicht befriedigt. Dabei wurde insbesondere nicht die notwendige Haftfestigkeit erzielt. Vielmehr besteht bei derart hergestellten Gegenständen die Gefahr des Lösens der genannten Zwischenschicht, und damit des gesamten Schichtpaketes. Dies kann dazu führen, dass der Gegenstand vorzeitig unbrauchbar wird.

Der Erfindung liegt somit die Aufgabe zugrunde, ein Verfahren sowie eine Vorrichtung anzugeben, mit welcher bzw. mit welchem ein Kunststoffsubstrat, insbesondere ein PMMA-umfassendes Substrat, mit einer Zwischenschicht, der sogenannten Haftvermittler-Schicht, sowie mindestens einer Funktionsschicht beschichtet werden kann. Die Zwischenschicht soll zuverlässig am Substrat anhaften, ebenso die einzelnen Schichten untereinander, so dass ein Ablösen ausgeschlossen ist. Verfahren und Vorrichtung sollen kostengünstig sein. Es soll ermöglicht werden, klimabeständige und/oder UV-beständige Produkte zu erzeugen. Außerdem soll durch die Erfindung ein entsprechendes Produkt angegeben werden, das sich durch eine zuverlässige Haftung zwischen Substrat, Zwischenschicht und Funktionsschicht(en) auszeichnet, das sich kostengünstig herstellen lässt und das gegebenenfalls klimabeständig und UV-beständig ist.

Eine weitere Aufgabe der vorliegenden Erfindung besteht darin, ein transparentes beschichtetes Substrat, das neben den optischen Funktionen den hohen Anforderungen an die Stabilität und Schichthaftung genügt, und ein wirtschaftliches und umweltfreundliches Verfahren zur Herstellung von transparenten beschichteten Substraten bereitzustellen.

Diese Aufgaben werden durch die in den Ansprüchen beschriebenen Ausführungsformen der vorliegenden Erfindung gelöst.

Insbesondere betrifft die vorliegende Erfindung ein Verfahren zum Beschichten eines Kunststoffsubstrats mit mindestens einer Funktionsschicht und mindestens einer, zwischen der bzw. den Funktionsschicht(en) und dem Substrat befindlichen Zwischenschicht, umfassend die folgenden Verfährensschritte:
(1) Aufbringen der Zwischenschicht auf das Substrat mittels eines PECVD-Verfahrens, wobei das Aufbringen bei minimaler Energiebelastung des Substrats erfolgt, und
(2) Aufbringen mindestens einer Funktionsschicht.

Erfindungsgemäß wird die Zwischenschicht und vorzugsweise auch mindestens eine Funktionsschicht durch ein sogenanntes PECVD-Verfahren (PEVCD "plasma enhanced chemical vapour deposition"), d.h. ein plasmaunterstütztes CVD-Verfahren, aufgebracht. Besonders bevorzugt werden alle Schichten durch das gleiche Verfahren aufgebracht.

Die Erfinder haben erkannt, dass bei den bisher angewandten PECVD-Verfahren zum Aufbringen von Schichten auf einem Substrat insbesondere die Grenzfläche bzw. das Interface zwischen der aufgebrachten Schicht und dem Substrat durch die damit verbundene Energiebelastung gestört oder in seiner Struktur zerstört wird. Dies hat eine Verringerung der Haftfähigkeit zwischen Substrat und angrenzender Schicht zur Folge. Demgemäß haben die Erfinder erkannt, dass die Energiebelastung, die mit der Plasmaentladung verbunden ist, minimiert werden muss, um die Haftung zu steigern. Dabei geht es sowohl um das Maß der aufgebrachten Energie als auch um die Art und Weise ihres Aufbringens. Der zulässige Grenzwert der Belastung zum Erzielen einer in der Praxis ausreichenden Haftung lässt sich durch den Versuch ermitteln.

Die beiden wesentlichen Wege zum Anwenden dieser Erkenntnis sind die folgenden:
Zum einen lässt sich die Energiebelastung dadurch in Grenzen halten, dass die Plasmaanwendung in gepulster Weise geschieht, dass heißt beispielsweise periodisch und somit in stets gleichbleibenden Intervallen oder intermittierend, wobei die Intervalle nicht gleichbleibend sein müssen. Dieses Verfahren wurde von der Anmelderin eingeführt und als "PICVD"-Verfahren (PICVD "plasma impulse chemical vapour deposition") bezeichnet. Wesentlich hierbei ist die erwähnte gepulste Betriebsweise. Hierdurch wird die Energiebelastung des Substrats verringert. Gleichzeitig bleibt die Verankerungswirkung, weiche die Plasmabehandlung zur Folge hat, erhalten.

Bei dem erfindungsgemäßen PICVD-Verfahren beträgt die Gesamtdauer der Plasmaeinwirkung wenigstens 1/1000 der einwirkungsfreien Zeitspanne zwischen zwei Plasmaimpulsen betragen und ist höchstens gleich dieser. Es ist gemäß dieser Ausführungsform des erfindungsgemäßen Verfahrens ferner bevorzugt, dassder Einwirkungspuls der Plasmabeaufschlagung zwischen 0,1 und 10 ms, mehr bevorzugt zwischen 0,5 und 5 ms, dauert.

Zum anderen lässt sich der genannte Grundgedanke der Erfindung, d.h. eine Verringerung der Energiebelastung der Grenzfläche zwischen Substrat und aufgebrachter Schicht, insbesondere auch durch das Anwenden einer hohen' Beschichtungsrate beim PECVD-Verfahrensschritt verwirklichen. Dies bedeutet, dass man die Schicht schnell an- bzw. aufwachsen lässt, somit möglichst viel Schichtsubstanz in einer möglichst kurzen Zeitspanne aufbringt. Vorzugsweise beträgt die pro Zeiteinheit aufgebrachte Schichtdicke, d.h. die Beschichtungsrate, bei der Plasmaeinwirkung mehr als 10 nm/min, mehr bevorzugt mehr als 100 nm/min. Eine solche hohe Beschichtungsrate sollte insbesondere zu Beginn der Beschichtung des Substrats gewählt werden.

Auch ist eine Kombination der beiden genannten Wege möglich. So kann die gepulste Verfahrensweise mit einer hohen Beschichtungsrate kombiniert werden. Durch diese Maßnahme werden besonders schonende Reaktionsbedingungen erreicht.

Erfindungsgemäß wird ein Kunststoffsubstrat beschichtet, wobei unter einem Kunststoff eine organische polymere Verbindung verstanden wird. Als solche Kunststoffe kommen Hochleistungskunststoffe in Betracht, die möglichst bis zu einer Temperatur von 100 °C oder mehr stabil sind. Auch bei noch wärmeempfindlicheren Kunststoffen wirkt sich das erfindungsgemäße Verfahren günstig aus, da die Substrattemperatur beim Beschichtungsvorgang, gemäß der Erfindung bei Raumtemperatur oder höchstens 40°C gehalten wird.

Vorzugsweise werden transparente Kunststoffe beschichtet. Beispielhaft können Kunststoffe wie Polymethylmethacrylat (PMMA), Polyethylenterephthalat (PET), Polycarbonat (PC), Polyetherimid, Cycloolefinpolymere (COP), Cycloolefincopolymere (COC) oder Gemische oder Blends davon genannt werden.

Dabei können die folgenden kommerziell erhältlichen Polymere Polymethylmethacrylat (Plexiglas®), Polycarbonat (Makrolon®), Cycloolefincopolymere (Topas®oder Zeonex®), Polyetherimid (Ultem®) oder Polyethersulfon (Ultrason®) verwendet werden.

Mit der Erfindung ist es insbesondere erstmals möglich, das schwer beschichtbare PMMA sowie dessen Derivate oder wesensgleiche Kunststoffe, d.h. Polymere und Copolymere von Acrylsäure und Methacrylsäure, sowie deren Derivate einschließlich Polyacrylnitril oder wesensgleiche Kunststoffe bei höchster Zuverläs sigkeit des Haftens mit einem Schichtpaket zu belegen, Damit lassen sich dünne, hochwertige Schichten im Mikrometer- oder Submikrometerbereich zuverlässig an das Substrat binden.

Eine bevorzugte Ausgestaltung der Erfindung ist ein transparentes beschichtetes Substrat, wobei mittels CVD mindestens eine Schicht mindestens eines Metalloxids auf das Substrat aufgebracht ist. Die Metalloxide sind bevorzugt Oxide der Metalle Si, Ti, Ta oder Nb. Zwar wird Si in der Regel als Halbmetall bezeichnet, da es sich jedoch in einem Verfahren gemäß der vorliegenden Erfindung wie eine Metallverbindung verhält, wird es gemäß dieser Erfindung der Gruppe der Metalle zugeordnet. Die Metalloxide sind besonders bevorzugt SiO₂, TiO_{2,} Ta₂O₅ oder Nb₂O₅. Mit diesen Metalloxiden werden sehr gute Ergebnisse bei der Schichthaftung erzielt.

In der Regel wird stets mindestens eine Silizium-haltige Schicht aufgetragen werden. Vorläuferverbindungen für eine Silizium-haltige Schicht geeignete Organosiliziumverbindungen schließen Silane, Siloxane und Silazane ein und sind beispielsweise eine der folgenden Verbindungen: Methylsilan, Dimethylsilan, Trimethylsilan, Diethylsilan, Propysilan, Phenylsilan, Hexamethyldisilan, 1,1,2,2-Tetramethyldisilan, Bis(trimethylsilyl)methan, Bis(dimethylsilyl)methan, Hexamethyldisiloxan, Vinyltrimethoxysilan, Vinyltriethoxysilan, Ethylmethoxysilan, Ethyltrimethoxysilan, Divenyltetramethyldisiloxan, Divinylhexamethyltrisiloxan und Trivinylpentamethyltrisiloxan, 1,1,2,2-Tetramethyldisiloxan, Hexamethyldisitoxan, Vinyltrimethylsilan, Methyltrimethoxysilan, Vinyltrimethoxysilan und Hexamethyldisilazan. Bevorzugte Siliziumverbindungen sind Tetramethyldisiloxan, Hexamethyldisiloxan (HMDSO), Hexamethyldisilazan, Tetramethylsilazan, Dimethoxydimethylsilan, Methyltrimethoxysilan, Tetramethoxysilan, Methyltriethoxysilan, Diethoxydimethylsilan, Methyltriethoxysilan, Triethoxyvinylsilan, Tetraethoxysilan, Dimethoxymethylphenylsilan, Phenyltrimethoxysilan, 3-Glycidoxypropyltrimethoxysilan, Diethoxymethylphenylsilan, Tris(2-methoxyethoxy)vinylsilan, Phenyltrieethoxysilan und Dimethoxydiphenylsilan.

Erfindungsgemäß wird auf das Substrat zunächst die sogenannte "Zwischenschicht" aufgetragen, welche als Haftvermittler-Schicht dient. Dieser kommt ganz entscheidende Bedeutung für die Brauchbarkeit des ganzen Produkts zu, da sie für eine Haftung des ganzen Schichtsystems am Substrat sorgt. Die Zwischenschicht kann eine einzige homogene Schicht sein. Sie kann auch eine Mehrlagenschicht sein. Im Falle einer solchen Mehrlagenschicht können die einzelnen Schichten einen Gradienten bilden, ausgehend von einer unmittelbar auf das Substrat folgenden Schicht, welche diesem als Organikum wesensgleich oder ähnlich ist, bis zu einer Schicht, auf welche die erste Funktionsschicht folgt und welche dieser als Anorganikum wesensgleich ist. Unter dem Begriff "Organikum" wird dabei verstanden, dass es sich um eine im wesentlichen organische, d.h. kohlenstoff- bzw. kohlenwasserstoffreiche Verbindung wie beispielsweise eine organische polymere Verbindung, handelt. Im Gegensatz dazu handelt es sich bei einem "Anorganikum" um eine anorganische, kohlenstoffarme Verbindung, wie beispielsweise ein Metalloxid. Die Zwischenschicht weist vorzugsweise eine Dicke von mindestens 10 nm, mehr bevorzugt von mindestens 200 nm oder auch 1000 nm, auf. Die Schicht kann beliebig dick hergestellt werden, jedoch sind Dicken oberhalb 2000 nm aufgrund einer verlängerten Herstellungszeit nicht mehr wirtschaftlich.

Erfindungsgemäß wird das Substrat neben der Zwischenschicht mit mindestens einer Funktionsschicht beschichtet. Vorzugsweise werden mindestens zwei Funktionsschichten aufgebracht, so dass sich ein Mehrschichtsystem ergibt.

Als Funktionsschichten können beispielsweise sogenannte optische Schichten, d.h. Schichten mit besonderen optischen Eigenschaften, wie einer bestimmten Transparenz, einem bestimmten Brechungsindex, einer bestimmten Farbigkeit usw., aufgetragen werden, beispielsweise eine Anti-Reflex-Schicht bzw. ein aus mehreren Einzelschichten bestehendes Anti-Reflex-Schicht-System.

Ferner können Funktionsschichten Schichten mit besonderen mechanischen Eigenschaften sein, wie beispielsweise eine Anti-Kratz-Schicht. Ferner kann eine hydrophobe Deckschicht, eine sogenannte Reinigungsschicht, welche sich mechanisch leicht reinigen lässt, aufgetragen werden. Weiter können solche Funktionsschichten dem Substrat Barriereeigenschaften, eine chemische, UV- oder Klima-Beständigkeit verleihen.

Derartige Funktionsschichten weisen beispielsweise jeweils eine Schichtdicke von 0,1 µm bis 5 µm auf. Es können je nach Verwendung jedoch auch Schichten im nm-Bereich aufgetragen werden.

Das Verfahren und die Vorrichtung zu dessen Durchführung sind besonders kostengünstig, weil vorzugsweise die gesamte Beschichtung mittels ein und derselben Einrichtung aufgebracht werden kann, d.h. dass alle Schichten in einem Arbeitsgang aufgetragen werden können. Praktische Versuche haben ergeben, dass die Schichten eine Prüfung der Haftfestigkeit mit dem Klebeband nach DIN 58 196, Teil 6, standhalten.

Ein weiterer wichtiger Vorteil sind die Klimabeständigkeit und die UV-Beständigkeit. Diese sind grundsätzlich erzielbar. So bestehen die Schichten Klimatests, die nach ISO 9022-2 durchgeführt werden, und anschließend einen Klebebandtest, wie oben beschrieben.

Die Erfindung ist bei jeglicher Art von Beschichtung anwendbar. Die Schichteigenschaften lassen sich durch die eingesetzten Rohstoffe sowie durch die Betriebsparameter der Anlage steuern. Die Schichteigenschaften lassen sich in weiten Grenzen verändern. Die Zwischenschicht ist vorzugsweise eine sogenannte Gradientenschicht, die aus mehreren Schichten zusammengesetzt ist, und bei der die substratnahe Schicht dem Substrat wesensgleich ist, und die substratferne Schicht den Funktionsschichten wesensgleich ist.

Die Erfindung lässt sich auch bei Verwendung des sogenannten Remote-PECVD-Verfahrens bzw. des Remote-PICVD-Verfahrens anwenden. Hierbei sind bekanntlich Plasmaraum und Beschichtungsraum voneinander getrennt. Aus dem Plasmaraum werden angeregte bzw. dissoziierte Species in den Beschichtungsraum geleitet.

Die Erfindung ist anhand der Zeichnung näher erläutert. Darin ist im einzelnen folgendes dargestellt:
Figur 1 veranschaulicht in einer perspektivischen Schnittdarstellung einen erfindungsgemäßen Körper.
Figur 2 zeigt in schematischer Darstellung eine Vorrichtung zum Beschichten eines Substrates.
Figur 3 zeigt in schematischer Darstellung eine bevorzugte Ausführungsform der vorliegenden Erfindung.
Figur 4 zeigt eine Überprüfung der Kratzfestigkeit eines erfindungsgemäß beschichteten Substrats.
Figur 5 zeigt die Anti-Reflexionseigenschaften eines erfindungsgemäß beschichteten Substrats.

Die vorliegende Erfindung betrifft ferner einen beschichteten Körper, welcher ein Kunststoffsubstrat, eine Zwischenschicht und mindestens eine, vorzugsweise mehrere Funktionsschicht(en) umfasst, wobei die Zwischenschicht zwischen dem Substrat und dem bzw. den Funktionsschicht(en) angeordnet ist, und wobei der beschichtete Körper nach dem erfindungsgemäßen Verfahren herstellbar ist.

Dabei kann es sich um Körper jeglicher Art und Gestalt handeln. In Betracht kommen insbesondere gekrümmte Körper oder leicht gekrümmte Körper, beispielsweise Brillengläser. Ferner kommen flache oder annähernd flache Körper wie Display-Abdeckscheiben, z. B. bei Mobilfunkgeräten, Telefon-Feststationen, usw. in Betracht.

Der erfindungsgemäße Körper umfasst als Kunststoff vorzugsweise einen der vorstehend genannten Kunststoffe, besonders bevorzugt Polymethylmethacrylat (PMMA) sowie dessen Derivate oder mit diesem wesensgleiche Kunststoffe.

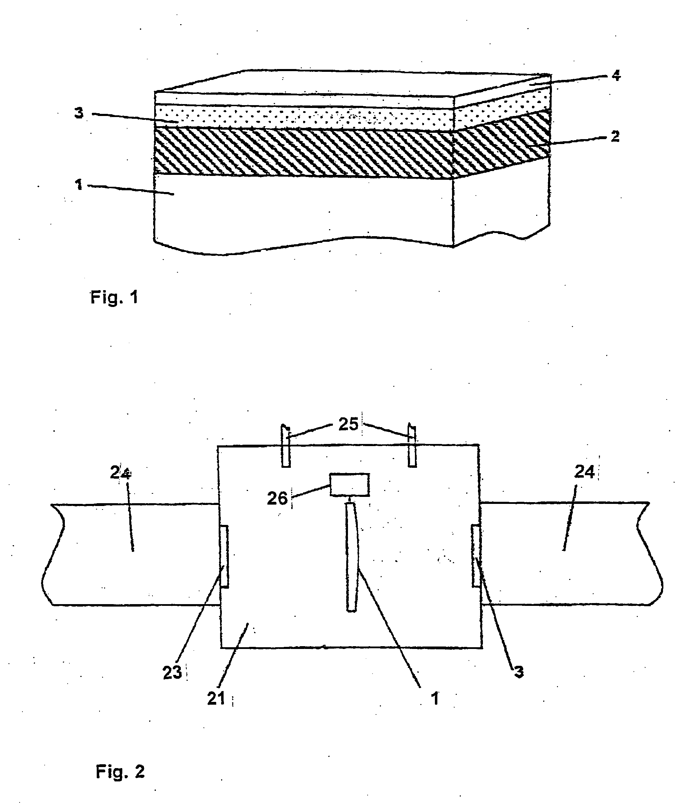

Figur 1 zeigt ein Beispiel eines erfindungsgemäß beschichteten Substrats. In Figur 1 erkennt man ein Substrat 1. Auf dieses ist eine Zwischenschicht 2 aufgebracht. Diese hat eine Haftvermittler-Funktion. Sie ist zuverlässig am Substrat verankert, weil sie erfindungsgemäß bei minimaler Energiebelastung auf das Substrat aufgebracht wurde. Die Zwischenschicht 2 kann eine sogenannte Gradientenschicht sein, aufgebaut aus mehreren Einzelschichten unterschiedlicher Zusammensetzung. Dabei ist die substratnahe Einzelschicht dem Substrat 1 wesensgleich, während die obere, substratferne Schicht einer nachfolgenden Schicht wesensgleich ist. Die nachfolgende Schicht ist die Funktionsschicht 3. Diese übt beispielsweise optische Funktionen aus. Den Abschluss bildet eine Deckschicht 4.

Die in Figur 2 gezeigte Vorrichtung weist die folgenden Komponenten auf:
Ein Beschichtungsreaktor 21 trägt das Substrat 1. Man erkennt ein Mikrowellenfenster 23, einen Mikrowellenhohlleiter 24, einen Gaseinlass 25 sowie einen Substrathalter 26.

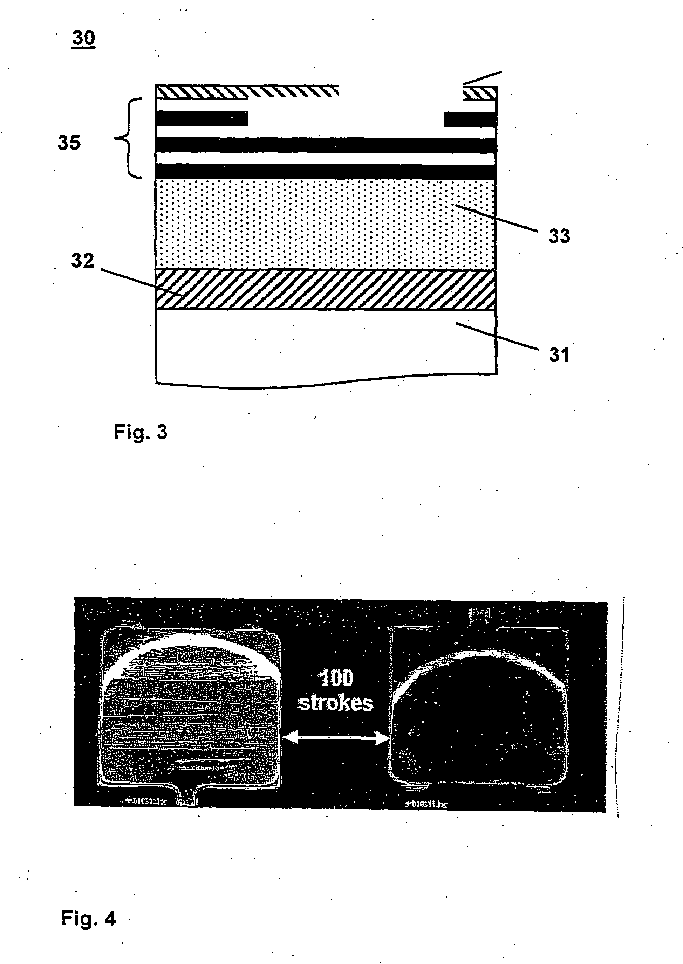

Figur 3 zeigt eine Schnittansicht einer bevorzugten Ausführungsform der vorliegenden Erfindung. Auf dem Substrat 31 ist eine Zwischenschicht 32 mit Haftvermittlerfunktion aufgetragen. Als nächstes folgt als erste Funktionsschicht eine Anti-Kratz-Schicht 33. Auf dieser ist eine Anti-Reflexions-Schicht 35 angeordnet, welche gemäß dieser Ausführungsform aus wechselnden Schichten wie beispielsweise insgesamt sechs SiO₂/TiO₂-Schichten besteht. Abschließend ist als Deckschicht eine Reinigungsschicht 34 angeordnet.

Die Substratoberfläche ist in Figur 3 eben eingezeichnet. Beispielsweise Handy-Displays weisen jedoch meist leicht oder stärker gekrümmte Oberflächen auf. Auch bei derartigen gekrümmten Oberflächen kann durch das erfindungsgemäße Verfahren eine gleichmäßige Beschichtung auf einer oder auch beiden Seiten eines Substrats erreicht werden.

Ein Schichtaufbau, wie in Figur 3 gezeigt, eignet sich insbesondere für Display-Abdeckungen, wie Handy-Displays. Als Substrat diente in diesem Beispiel PMMA. Alle Schichten wurden mittels PICVD-Verfahren sukzessive mit der selben PICVD-Einrichtung in einem einzigen Arbeitsgang aufgebracht. Dabei erfolgte der Energieeintrag zur Zündung des Plasmas in der Kammer in Form von Mikrowellen bei einer Frequenz von typischerweise 2,45 GHz. Die unterschiedlichen Schichten ergaben sich aus unterschiedlichen Verfahrensbedingungen und/oder in die Kammer eingespeisten Vorläuferverbindungen ggf. in Kombination mit Sauerstoff und/oder weiteren Träger- bzw. Reaktionsgasen. Beispielsweise ist die Haftvermittlerschicht noch kohlenstoffreich und dem organischen PMMA-Substrat wesensgleich. Diese Schicht ist durch ihre polymere Beschaffenheit flexibel. Überraschenderweise wurde festgestellt, dass mittels des erfindungsgemäßen Verfahrens die Haftvermittlerschicht auch auf einem ansonsten schwer beschichtbaren PMMA-Substrat unerwartet gut haftet, wobei gleichzeitig keine Beschädigung der Oberfläche des Substrats auftritt. Bei der darauf aufgebrachten Anti-Kratz-Schicht 33 handelt es sich um eine Beschichtung mit einem geringeren Kohlenstoffgehalt, welche sich durch eine größere Härte auszeichnet. Zur Herstellung dieser Schichten 32 und 33 kann die gleiche siliziumorganische Ausgangsverbindung, wie beispielsweise Hexamethyldisiloxan (HMDSO), verwendet werden, wobei zur Herstellung einer anorganischen Beschichtung auch Sauerstoff in das System eingeleitet wird. Je nach Verfahrensbedingungen entsteht durch vollständige Oxidation des Kohlenwasserstoffanteils von HMDSO zu Kohlendioxid und Wasser eine reine anorganische Quarzbeschichtung oder bei unvollständiger Oxidation eine kohlenstoffreiche organische Polymerverbindung. Dabei kann der Übergang von einer solchen Zwischenschicht zu der Anti-Kratz-Schicht auch durch graduelle Änderung der Verfahrensbedingungen als Gradientenschicht ausgestaltet werden. Zur Herstellung einer TiO₂-Schicht wird eine Vorläuferverbindung wie TiCl₄ zusammen mit Sauerstoff in das System eingeleitet. Vorzugsweise wird das nach der Plasmaentladung in der Kammer enthaltene Gas nach jedem Puls gewechselt, so dass im Plasma selbst kein Gradient entsteht. Dadurch kann eine sehr einheitliche Beschichtung erreicht werden.

Das so erhaltene Mehrschichtsystem ist klimabeständig und hielt einer Prüfung der Haftfestigkeit wie vorstehend beschrieben stand.

Durch das gepulste Verfahren konnte bei sehr niedrigen Temperaturen auch bei Raumtemperatur gearbeitet werden, so dass keine Beschädigung der Substratoberfläche bzw. der Grenzfläche zwischen Substrat und Zwischenschicht auftritt. Ferner konnte eine geschlossene und sehr homogene Beschichtung erreicht werden.

Figur 4 zeigt fotografische Abbildungen eines erfindungsgemäß beschichteten PMMA-Substrats (rechtes Bild) verglichen mit einem nicht beschichteten PMMA-Substrat (linkes Bild). Die Substrate wurden einem Kratztest unterworfen, wobei die Oberfläche gemäß DIN 58196, Teil 5, mit einem sogenannten Cheesecloth und einer Auflagekraft von 450 g 100mal gerieben wurde. Auf dem nichtbeschichteten Substrat sind deutlich Kratzspuren zu erkennen, wohingegen das erfindungsgemäß beschichtete Substrat eine unbeschädigte Oberfläche zeigt.

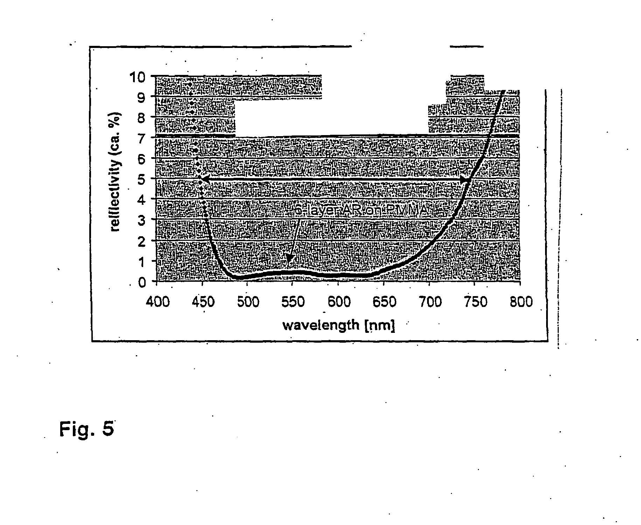

Figur 5 zeigt die reflexionsmindernden Eigenschaften einer wie in dem vorstehenden Beispiel enthaltenen Anti-Reflexions-Schicht auf einer PMMA-Oberfläche. Während unbeschichtetes PMMA eine Basislinienreflexion von etwa 7% aufweist, ist die Reflexion eines erfindungsgemäß beschichteten Substrats im Bereich des sichtbaren Lichts deutlich abgesenkt.

Die vorliegende Erfindung betrifft ferner ein transparentes beschichtetes Substrat, das ein organisches polymeres Substrat und mindestens auf einer Seite des Substrats mindestens eine mittels CVD aufgebrachte dielektrische Schicht enthält.

Das polymere Substrat wird bevorzugt mittels eines gepulsten, plasmagestützten CVD-Verfahrens (PICVD) beschichtet. Das Plasma wird dabei durch die Einstrahlung von Mikrowellen erzeugt. Das Verfahren bietet die folgenden Vorteile:
(i) Durch geeignete Wahl der Pulszyklen und der in das Plasma eingebrachten Pulsleistung kann die Wärmebelastung der Polymersubstrate bei der Beschichtung bei gleichzeitig hoher Qualität und Haftung der abgeschiedenen Schichten sehr gering gehalten werden.
(ii) Neben den Parametern der Plasmapulsung bietet das Verfahren eine Reihe weiterer Prozessfreiheitsgrade, mit denen sich die Eigenschaften der sukzessiv aufgebrachten Schichten gezielt beeinflussen und im Hinblick auf die Anforderungen an die Stabilität optimieren lassen.

Eine bevorzugte Ausgestaltung der Erfindung ist ein transparentes beschichtetes Substrat, wobei das organische polymere Substrat mindestens eines der Polymere wie Polycarbonat, Polyetherimid, .Polymethylmethacrylat, zyklische Olefine oder Olefincopolymere oder Gemische und Blends davon oder mindestens ein thermoplastisches amorphes Harz enthält.

Dabei können die folgenden kommerziell erhältlichen Polymere Polycarbonat (Makrolon^{®}), Cycloolefincopolymere (Topas^{®}oder Zeonex^{®}), Polyetherimid (UI-tem^{®}) oder Polyethersulfon (Ultrason^{®}) verwendet werden.

Eine weitere bevorzugte Ausgestaltung der Erfindung ist ein transparentes beschichtetes Substrat, wobei mittels CVD mindestens eine Schicht mindestens eines Metalloxids auf das Substrat aufgebracht ist. Die Metalloxide sind bevorzugt Oxide der Metalle Si, Ti, Ta oder Nb. Die Metalloxide sind besonders bevorzugt SiO₂, TiO₂, Ta₂O₅ oder Nb₂O₅. Mit diesen Metalloxiden werden sehr gute Ergebnisse bei der Schichthaftung erzielt.

Eine weitere bevorzugte Ausgestaltung der Erfindung ist ein transparentes beschichtetes Substrat, wobei die Schicht auf dem Substrat optional eine Zwischenschicht und darauf eine Antireflexschicht und darauf optional eine Deckschicht enthält und die Zwischenschicht, Antireflexschicht und Deckschicht mindestens eine Schicht enthalten. Alle diese Schichten werden vorteilhaft in einem Verfahren aufgebracht.

Eine weitere bevorzugte Ausgestaltung der Erfindung ist ein transparentes beschichtetes Substrat, wobei die Dicke der Zwischenschicht von bis zu 10 µm, die der Antireflexschicht von 50 nm bis 1 µm und die der Deckschicht von 0 bis 1 µm beträgt. Bei diesen Schichtdicken werden sehr gute Ergebnisse bei der Schichthaftung erzielt.

Das erfindungsgemäße transparente beschichtete Substrat weist eine planare, plankonvexe, bikonvexe, plankonkave, bikonkave, konkav-konvexe oder beliebige asphärische Form auf.

Erfindungsgemäß ist ein Verfahren zur Herstellung eines transparent beschichteten Substrats vorgesehen, wobei auf das transparente Substrat mittels CVD, bevorzugt mittels PICVD oder PECVD, optional eine Zwischenschicht und darauf eine Antireflexschicht und darauf optional eine Deckschicht aufgebracht wird.

Erfindungsgemäß ist die Verwendung des transparenten beschichteten Substrates als optische Linse vorgesehen. Erfindungsgemäß ist weiter die Verwendung des transparenten beschichteten Substrates als Bestandteil in beleuchtenden oder abbildenden optischen Systemen vorgesehen. Die erfindungsgemäßen optischen Systeme weisen sehr gute optische Eigenschaften auf und genügen den Anforderung an die Stabilität und die Schichthaftung.

Diese Ausführungsform der vorliegenden Erfindung wird nachfolgend anhand eines weiteren Beispiels näher erläutert.

Es wurde eine Linse aus dem Material Topas 6015® in einen Beschichtungsreaktor mit spezieller Probenhalterung eingebracht. Nach Evakuierung auf einen Druck in der Größenordnung von 1 mbar folgte eine kurze PlasmaVorbehandlung zur Aktivierung der Substratoberfläche. Anschließend wurde eine Zwischenschicht und darauf ein Antireflex-Schichtpaket bestehend aus 4 Schichten mit SiO₂ als niedrigbrechendem und TiO₂ als hochbrechendem Schichtmaterial auf der Linse abgeschieden. Dabei betrug das Tastverhältnis der Plasmapulsung etwa 5%. Die Substrattemperatur während der Beschichtung betrug 30 °C. Die beschichteten Linsen wurden neben der Messung ihrer spektralen Transmission folgenden Tests unterzogen:
(i) Tape Test (Klebebandtest),
(ii) Langsamer Temperaturwechsel zwischen 20 °C und 85 °C, bei einer Verweilzeit jeweils 2,5 h (5 Zyklen),
(iii) Konstantklima, 16 h bei 55 °C und 100% relativer Feuchte.

Nach dem Tape Test traten keine Delaminationen des Schichtpaketes auf. Ebenso zeigten sich nach dem Temperaturwechsel- und Konstantklimatest keine Delaminationen. Die beschichtete Linse wies eine gleichbleibende Brillanz auf. Fehlermerkmale der Beschichtung wie zum Beispiel Risse oder Trübungen wurden nicht beobachtet. Dementsprechend ergaben Messungen der optischen spektralen Eigenschaften keine Veränderung nach Temperaturwechsel- und Konstantklimatest.

## Patentansprüche

1. Verfahren zum Beschichten eines Kunststoffsubstrats mit mindestens einer Funktionsschicht und mindestens einer, zwischen der bzw. den Funktionsschicht (en) und dem Substrat befindlichen Zwischenschicht, umfassend die folgenden Verfahrensschritte:
(1) Aufbringen der Zwischenschicht auf das Substrat mittels eines PICVD-Verfahrens, wobei das Aufbringen bei minimaler Energiebelastung des Substrats erfolgt, und
(2) Aufbringen mindestens einer Funktionsschicht, wobei die Gesamtdauer der Plasmaeinwirkung wenigstens 1/1000 der einwirkungsfreien Zeitspanne zwischen zwei Plasmaimpulsen beträgt und höchstens gleich dieser ist und wobei die Substrattemperatur beim Beschichtungsvorgang bei höchstens 40 °C, vorzugsweise bei Raumtemperatur gehalten wird.

2. Verfahren nach Anspruch 1, wobei auf die Zwischenschicht mindestens zwei Funktionsschichten aufgetragen werden.

3. Verfahren nach Anspruch 1 oder 2 wobei der Einwirkungspuls der Plasmabeaufschiagung zwischen 0,1 und 10 ms dauert.

4. Verfahren nach einem der vorangehenden Ansprüche, wobei ein Kunststoffsubstrat beschichtet wird, welches Polymethylmethacryiat (PMMA) oder ein Derivat hiervon oder einen mit diesem wesensgleichen Kunststoff umfasst.

5. Verwendung eines Verfahrens nach einem der Ansprüche 1 bis 4 zur Herstellung von Display-Abdeckscheiben.

6. Verwendung eines Verfahrens nach einem der Ansprüche 1 bis 4 zur Herstellung von optischen Linsen.

## Claims

1. Method for coating a synthetic material substrate having at least one functional layer and at least one intermediate layer located between the functional layer(s) and the substrate, including the following method steps:
(1) applying the intermediate layer to the substrate by means of a PICVD method, wherein the application is carried out with minimal energy loading of the substrate, and
(2) applying at least one functional layer, wherein the total duration of the plasma action amounts to at least 1/1000 of the action free interval between two plasma impulses and is at most equal to this interval and wherein the substrate temperature during the coating process is kept at a maximum of 40°C, preferably at ambient temperature.

2. Method as claimed in claim 1, wherein at least two functional layers are applied to the intermediate layer.

3. Method as claimed in claim 1 or 2, wherein the action pulse of the plasma application lasts between 0.1 and 10 ms.

4. Method as claimed in any one of the preceding claims, wherein a synthetic material substrate is coated, which includes polymethyl methacrylate (PMMA) or a derivative thereof or a synthetic material essentially identical in nature thereto.

5. Use of a method as claimed in any one of claims 1 to 4 for producing display cover plates.

6. Use of a method as claimed in any one of claims 1 to 4 for producing optical lenses.

## Revendications

1. Procédé de revêtement d'un substrat en matière synthétique avec au moins une couche fonctionnelle et au moins une couche intercalaire située entre la ou les couches fonctionnelles et le substrat, comprenant les étapes de procédé suivantes :
(1) application de la couche intercalaire sur le substrat en recourant à un procédé PICVD, l'application étant effectuée avec une sollicitation d'énergie minimale pour le substrat, et
(2) application d'au moins une couche fonctionnelle, la durée totale d'action du plasma correspondant au minimum à 1/1000^{e} de l'intervalle temporel exempt d'action entre deux impulsions de plasma et étant au maximum égale à celui-ci, et la température du substrat étant maintenue à 40°C au maximum, préférentiellement à température ambiante pendant le revêtement.

2. Procédé selon la revendication 1, où au moins deux couches fonctionnelles sont appliquées sur la couche intercalaire.

3. Procédé selon la revendication 1 ou 2, où la durée d'une impulsion efficace de l'application de plasma est comprise entre 0,1 et 10 ms.

4. Procédé selon l'une des revendications précédentes, où un substrat en matière synthétique est revêtu, lequel comprend du polyméthacrylate de méthyle (PMMA) ou un dérivé de celui-ci, ou une matière synthétique de même nature.

5. Utilisation d'un procédé selon l'une des revendications 1 à 4 pour la fabrication de vitres de protection d'écrans.

6. Utilisation d'un procédé selon l'une des revendications 1 à 4 pour la fabrication de lentilles optiques.
